# EUROPÄISCHE PATENTSCHRIFT

(11) **EP 0 503 108 B1**
(45) Veröffentlichungstag und Bekanntmachung des Hinweises auf die Patenterteilung: **27.12.1995**
(21) Anmeldenummer: 91103700.0
(22) Anmeldetag: 11.03.1991
(51) Int. Cl.: G01R 33/035

(54) **SQUID-Messeinrichtung mit Abschirmmitteln**
Squid measurement system with screening means
Système de mesure squid avec blindage

(43) Veröffentlichungstag der Anmeldung: 16.09.1992
(73) Patentinhaber: SIEMENS AKTIENGESELLSCHAFT, 80333 München (DE)
(72) Erfinder: Uhl, Dieter, Dipl.-Ing. (FH), W-8525 Uttenreuth (DE); Seifert, Heinrich, Dr., W-8526 Bubenreuth (DE)

(56) Entgegenhaltungen:
- EP-A- 0 184 670
- EP-A- 0 185 186
- EP-A- 0 200 080
- EP-A- 0 399 499
- REVIEW OF SCIENTIFIC INSTRUMENTS. Bd. 59, Nr. 4, April 1988, NEW
- YORK US Seiten 624 - 626; VAN DER WEL ET AL: 'Cryogenic current comparator with increased resolution'
- IEEE TRANSACTIONS ON INSTRUMENTATION AND MEASUREMENT. Bd. IM-26, Nr. 1, März 1977, NEW YORK US Seiten 25 - 28; H. NAKANE ET AL: 'Improving the Frequency Characteristics of RF Standard Magnetic-Field Generator Employing Loop Antenna'
- IBM TECHNICAL DISCLOSURE BULLETIN. Bd. 27, Nr. 10A, März 1985, NEW YORK US Seiten 5847 - 5848; 'Integrated Thin-Film Miniature SQUID Magnetometer'
- TECHNISCHES MESSEN TM. Bd. 53, Nr. 7/8, 1986, MUNCHEN DE Seiten 266 - 280; HG. MEYER: 'Störfestigkeit von Messsystemen'
- REVIEW OF SCIENTIFIC INSTRUMENTS. Bd. 47, Nr. 3, März 1976, NEW YORK US Seiten 387 - 388; J.W. THOMASSEN ET AL.: 'Magnetic Field Shielding by a Superconducting Cylindrical Tube of Finite Length'
- IEEE Transactions on Instrumentation and Measurement, Band. IM-23, Nr. 4, Dezember 1974, Seiten 256 - 260

## Beschreibung

Die Erfindung bezieht sich auf eine SQUID-Meßeinrichtung zur Erfassung schwacher, sich zeitlich ändernder magnetischer Feldsignale mindestens einer insbesondere biomagnetischen Feldquelle, welche Einrichtung mindestens einen Meßkanal enthält mit einen SQUID, mit einem dem SQUID vorangeordneten supraleitenden Flußtransformator, der wenigstens eine Detektionsschleife zum Empfang der Feldsignale und wenigstens einen an diese Schleife angeschlossenen Verbindungsleiter aufweist, sowie mit mindestens einem supraleitenden Abschirmelement, das zu einem elektrischen Abschirmen des wenigstens einen Verbindungsleiters parallel zu diesem angeordnet ist. Eine derartige SQUID-Meßeinrichtung ist z.B. aus der EP-B-0 185 186 bekannt.

Mit supraleitenden Quanten-Interferometern, die auch als "SQUIDs" (Abkürzung von: Superconducting QUantum Interference Devices) bezeichnet werden, sind insbesondere äußerst schwache magnetische Felder zu messen (vgl. z.B. "IEEE Trans. El. Dev.", Vol. ED-27, No. 10, Okt. 1980, Seiten 1896 bis 1908). Als bevorzugtes Anwendungsgebiet für SQUIDs wird deshalb auch die medizinische Diagnostik angesehen, da die dort auftretenden biomagnetischen Signale, z.B. die vom menschlichen Herzen oder vom menschlichen Gehirn erzeugten Magnetfelder, nur Feldstärken im pT-Bereich hervorrufen (Magnetokardiographie bzw. Magnetoenzephalographie).

Eine entsprechende Einrichtung zur Erfassung und Aufbereitung derartiger schwacher orts- und zeitabhängiger Magnetfelder enthält mindestens einen Meß- oder Detektionskanal. Dieser Kanal weist einen sogenannten Flußtransformator mit wenigstens einer als Gradiometer oder Magnetometer gestalteten Antenne und gegebenenfalls mit einer Koppelspule, ferner einen dem Flußtransformator nachgeordneten SQUID-Kreis mit in ihn integriertem SQUID, im allgemeinen eine Modulationsspule, Verstärker sowie eine Auswerteelektronik auf. Bis auf die Verstärker und Auswerteelektronik bestehen die genannten Teile aus supraleitendem Material und sind in einem entsprechenden Kryosystem untergebracht, um in ihnen supraleitende Betriebsbedingungen zu ermöglichen. Die Antenne wird von mindestens einer Detektionsschleife zum Erfassen der Feldsignale der zu detektierenden Feldquelle gebildet. Das entsprechende Meßsignal gelangt dann über mindestens einen mit der Detektionsschleife verbundenen supraleitenden Verbindungsleiter in den SQUID-Kreis. Zur Messung des in diesen Kreis eingekoppelten Flusses oder von Flußgradienten werden sowohl RF- SQUIDs (Hochfrequenz- bzw. Radio-Frequency-SQUIDs) als auch DC-SQUIDs (Gleichstrom- bzw. Direct-Current-SQUIDs) eingesetzt. Eine Meßeinrichtung mit einer Vielzahl von entsprechend ausgestalteten Meßkanälen geht z.B. aus der Veröffentlichung "Cryogenics", Vol. 29, August 1989, Seiten 809 bis 813 hervor.

Beim Betrieb von offenen SQUID-Meßeinrichtungen, bei denen sich die Feldquellen, wie z.B. bei biomagnetischen Messungen, außerhalb des Kryosystems befinden, ergeben sich erhebliche Probleme durch hochfrequente, elektromagnetische Einstrahlungen in die feldsensitiven Teile der Meßeinrichtung. Die hochfrequenten Störungen, die hauptsächlich über schlecht filterbare Anschlüsse des Flußtransformators zum SQUID gelangen, verwischen die Struktur der nichtlinearen SQUID-Kennlinie und verkleinern dadurch das vom SQUID gelieferte Signal. Dies führt in der Meßeinrichtung zu einem Anstieg des Rauschens, zu einer unerwünschten Detektion von Frequenz und Amplitude des meist instabilen Störers oder gegebenenfalls sogar zum völligen Ausfall des entsprechenden Meßkanals.

Da in die Leitungen des Flußtransformators keine wirksamen Hochfrequenzfilter eingefügt werden können und zudem die meisten Meßaufbauten der Einrichtung wegen der niedrigen zu detektierenden Frequenzen nicht hochfrequenzgerecht ausgelegt sind, wird bisher hauptsächlich mit passiven Abschirmmaßnahmen gearbeitet. Diese wurden jedoch im allgemeinen nicht in unmittelbarer Nähe des Flußtransformators, insbesondere seiner mindestens einen Detektionsschleife, vorgenommen, da hier der Einsatz von normalleitenden Materialien aufgrund thermischer Fluktuationen zu einem Rauschanstieg im Meßkanal führt, supraleitende Materialien hingegen das zu detektierende Feldsignal verzerren oder gänzlich verdrängen. Aus diesem Grunde ist bei der aus der eingangs genannten EP-B bekannten Meßeinrichtung auch nur eine Abschirmung mittels einer supraleitenden Leiterbahn längs der Verbindungsleiter des Flußtransformators vorgesehen.

Wegen der erwähnten Probleme kann man z.B. den gesamten Meßraum in einer Abschirmkammer unterbringen (vgl. die genannte Textstelle aus "Cryogenics" oder "Biomagnetism - Proceedings Third International Workshop on Biomagnetism -, Berlin, Mai 1980", 1981, Seiten 51 bis 78). Hierbei sind jedoch aufwendige Filter für elektrische Versorgungsleitungen oder optische Datenübertragungsteile erforderlich. Auch sind provisorische Abschirmungen mit Aluminiumfolien an der Außenwand eines SQUID-Meßsystems bekannt. Solche Abschirmungen sind jedoch nicht sehr wirkungsvoll und erhöhen zudem das Rauschen.

Aufgabe der vorliegenden Erfindung ist es, die Meßeinrichtung mit den eingangs genannten Merkmalen, die als Magnetometer oder Gradiometer gestaltete Detektionsschleifen aufweisen kann, dahingehend auszugestalten, daß gegenüber dem Stand der Technik nur ein reduzierter Aufwand an Maßnahmen zur Abschirmung notwendig ist.

Diese Aufgabe wird erfindungsgemäß mit den in Anspruch 1 angegebenen Maßnahmen gelöst.

Die erfindungsgemäßen Maßnahmen beinhalten somit eine praktisch vollständige elektrische Abschirmung der Teile des Flußtransformators, welche bezüglich der zu detektierenden Feldsignale und unerwünschten Störsignale offenliegen. Die Abschirmung erfolgt dabei mit Hilfe der Anordnung einer supraleitenden Leiterstruktur in unmittelbarer Nähe der Leiter dieser offenliegenden Transformatorteile. Dabei ist an einer Stelle am Umfang der mindestens einen Detektionsschleife eine vollständige Unterbrechung der Abschirmung vorgesehen, damit die Schleife zwar gegen elektrische, nicht aber gegen die zu messenden Magnetfelder abgeschirmt wird. Dadurch, daß sich das entsprechende supraleitende Abschirmelement in unmittelbarer Nähe des Detektionsleiters befindet, verursacht es vorteilhaft keine nennenswerten Feldverzerrungen. Durch die Verwendung eines supraleitenden Materials werden außerdem keine Rauschströme in der Detektionsschleife induziert. Ein weiterer erheblicher Vorteil der erfindungsgemäßen Maßnahmen ist darin zu sehen, daß sich das supraleitende Abschirmelement auf sehr einfache Weise realisieren läßt.

Aus "Rev. Sci. Instrum.", Vol. 59, No. 4 (1988), Seiten 624 bis 626 geht ein kryogener Stromkomparator hervor, der supraleitende Leiterschleifen enthält, die von einer unterbrochenen supraleitenden Abschirmung umhüllt sind. Die Leiterschleifen dienen zur Erzeugung eines Magnetfeldes. Die supraleitende Abschirmung hat die Aufgabe, die von ihr umschlossenen Leiterschleifen magnetisch fest zu koppeln, damit deren Ströme verglichen werden können (Komparatorfunktion). Die bekannte Einrichtung verfolgt somit einen anderen Zweck.

Vorteilhafte Ausgestaltungen der erfindungsgemäßen Meßeinrichtung gehen aus den Unteransprüchen hervor.

Zur weiteren Erläuterung der Erfindung wird nachfolgend auf die Zeichnung Bezug genommen, in deren Figuren 1 und 2 ein Längs- bzw. Querschnitt durch einen Flußtransformator einer erfindungsgemäßen Meßeinrichtung schematisch veranschaulicht ist. Die Figuren 3 und 4 zeigen schematisch als Aufsicht bzw. als Querschnitt einen weiteren Flußtransformator. In den Figuren sind sich entsprechende Teile mit denselben Bezugszeichen versehen.

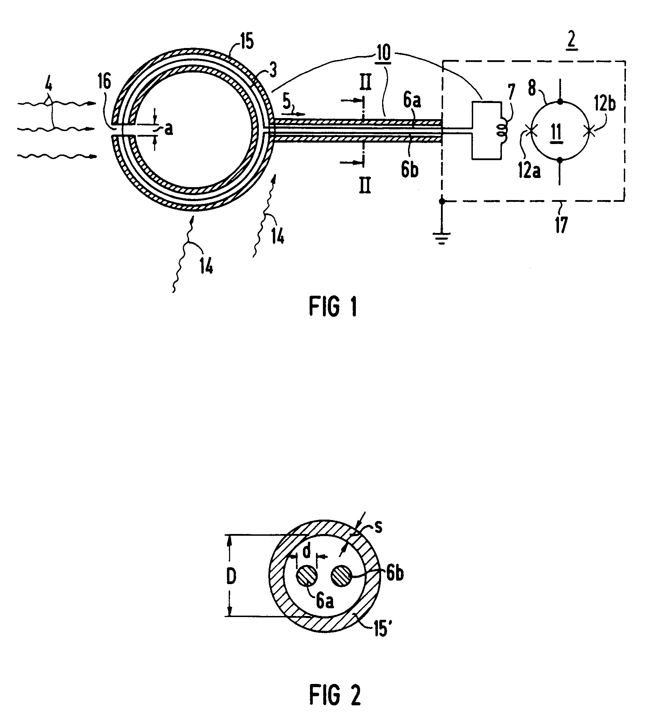

Die in Figur 1 gezeigten Teile einer Meßeinrichtung nach der Erfindung sollen sich auf einer zur Kühlung des für sie verwendeten supraleitenden Materials hinreichenden Tieftemperatur, insbesondere auf der Siedetemperatur des flüssigen Heliums (LHe) von 4,2 K befinden. Gegebenenfalls können die supraleitenden Teile auch aus bekannten metalloxidischen HochT_{c}-Supraleitermaterialien hergestellt sein, die sich mit flüssigem Stickstoff (LN₂) kühlen lassen. Die allgemein mit 2 bezeichnete Meßeinrichtung kann einen oder mehrere parallele Meßkanäle aufweisen. In der Figur nicht näher ausgeführte Teile der Meßeinrichtung sind an sich bekannt (vgl. die genannte Veröffentlichung "Cryogenics" oder die EP-A-0 359 864). Der dem Ausführungsbeispiel zugrundegelegte eine Meßkanal enthält als Antenne für ein von mindestens einer zu detektierenden Feldquelle erzeugtes magnetisches Feld eine ein Magnetometer bildende Detektionsschleife 3. Das Feldsignal 4 kann insbesondere im Falle einer biomagnetischen Feldquelle verhältnismäßig niederfrequent sein. Es ruft an der Detektionsschleife 3 ein allgemein mit 5 bezeichnetes Meßsignal hervor. Dieses Meßsignal wird über zwei supraleitende Verbindungsleiter 6a und 6b einer Koppelspule 7 zugeführt, über die es induktiv in eine Schleife 8 eines SQUIDs eingekoppelt wird. Die Detektionsschleife 3, die Verbindungsleiter 6a und 6b sowie die Koppelspule 7 stellen so einen allgemein mit 10 bezeichneten supraleitenden Flußtransformator da. Gemäß dem Ausführungsbeispiel ist ein DC-SQUID 11 mit zwei Josephson-Tunnelelementen 12a und 12b angenommen. Es können jedoch auch RF-SQUIDs verwendet werden. Das mit Hilfe des SQUIDs 11 erzeugte SQUID-Signal wird dann einer nachgeordneten signalverarbeitenden Elektronik zur Weiterverarbeitung und Darstellung zugeleitet. Diese an sich bekannten Teile einer Meßeinrichtung sind in der Figur nicht dargestellt und befinden sich im allgemeinen auf Raumtemperatur.

Gemäß der Erfindung sind zusätzliche Maßnahmen zu einer Abschirmung der offenliegenden, d.h. einer höherfrequenten, elektromagnetischen Einstrahlung 14 einer Störquelle ausgesetzten Teile des Flußtransformators 10 vorgesehen. Hierzu ist parallel zu den offenliegenden Teilen der Verbindungsleiter 6a und 6b sowie zu der wenigstens einen Detektionsschleife 3 mindestens ein supraleitendes Abschirmelement 15 jeweils in deren unmittelbarer Nähe angeordnet. Dieses Element muß an einer Trennstelle 16 am Umfang der Detektionsschleife eine vollständige, beispielsweise schlitzartige Unterbrechung aufweisen, damit die Schleife zwar gegen elektrische, nicht aber gegen die zu detektierenden Feldsignale 4 abgeschirmt ist. Die Ausdehnung a der Trennstelle 16 in Umfangsrichtung der Schleife (= Längsausdehnung des Schleifenleiters) kann z.B. für übliche Durchmesser der Schleife 3 von etwa 2 cm zwischen 0,1 und 0,5 mm liegen.

Die Detektionsschleife 3 und die Verbindungsleiter 6a und 6b können z.B. aus einem supraleitenden Draht hergestellt sein. Wie insbesondere aus dem in Figur 2 dargestellten Querschnitt, der in die in Figur 1 mit II-II gekennzeichnete Schnittlinie im Bereich der Verbindungsleiter gelegt ist, hervorgeht, ist für eine derartige Drahtversion ein supraleitendes Abschirmelement 15 in Form einer kapillarartigen (rohrförmigen) Hülle 15′ geeignet. Diese Hülle kann z.B. aus mehreren rohrförmigen Teilstücken zusammengesetzt sein. Gemäß dem dargestellten Ausführungsbeispiel umschließt eines der Teilstücke gemeinsam die beiden Verbindungleiter 6a und 6b, während mindestens ein weiteres Teilstück bis auf die Trennstelle 16 die Detektionsschleife 3 umhüllt. Ferner ist es auch möglich, die beiden Verbindungsleiter jeweils in einem eigenen Hüllrohr anzuordnen, wobei jedes Hüllrohr bis zu der Trennstelle 16 verlaufen kann und damit eine Hälfte der Detektionsschleife mit umschließt. In diesem Falle sind die beiden Hüllrohre zumindest im Bereich der Enden der beiden Verbindungsleiter supraleitend zu verbinden (kurzzuschließen).

Wie außerdem aus Figur 1 hervorgeht, ist die Hülle mit einer durch eine gestrichelte Linie angedeuteten, auf Erdpotential gelegten Abschirmung 17 des SQUID-Bereichs verbunden und damit ebenfalls geerdet. Falls ein Ende der Detektionsschleife 3 selbst auf Erdpotential gelegt ist, kann gegebenenfalls auch nur ein einziger von der Hülle 15′ umschlossener Verbindungsleiter erforderlich sein.

Das kapillarartige Abschirmelement 15 bzw. die Hülle 15′ kann im Rahmen einer LHe-Technologie aus einem dünnwandigen Hohlrohr aus einem bekannten supraleitenden Material wie z.B. aus Nb, einer Nb-Legierung oder -Verbindung, aus Pb oder einer Pb-Legierung oder aus einer In-Legierung bestehen. So hat z.B. eine Pb-Sn-Legierung den zusätzlichen Vorteil einer leichten Lötbarkeit. Für supraleitende Drähte der Leiterteile 3, 6a und 6b mit einem Durchmesser d von z.B. 50 bis 150 »m kann der Innendurchmesser D der Hülle 15′ z.B. zwischen 200 und 300 »m und die Wandstärke s z.B. zwischen 150 und 350 »m betragen.

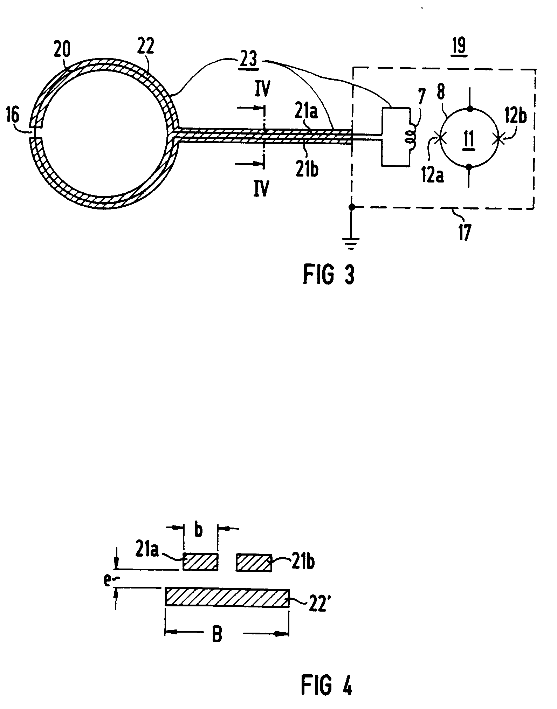

Dem Ausführungsbeispiel nach den Figuren 1 und 2 wurde zwar eine Drahtversion zugrundegelegt. Ebensogut lassen sich die einzelnen Leiter des Flußtransformators sowie die erfindungsgemäßen Abschirmmaßnahmen auch in Dünnfilm-Technik realisieren. Für das in den Figuren 3 und 4 gezeigte Ausführungsbeispiel einer erfindungsgemäßen Meßeinrichtung 19 ist eine entsprechende Version angenommen, wobei für Figur 3 eine Aufsicht und für Figur 4 ein Querschnitt entsprechend Figur 2 in einer in Figur 3 mit IV-IV bezeichneten Schnittebene gewählt ist. Bei dieser Filmversion werden der Leiter einer Detektionsschleife 20 einzeln und die offenliegenden Leiterteile von Verbindungsleitern 21a und 21b parallel zueinander über einer als Abschirmelement 22 dienenden supraleitenden Leiterbahn 22′ geführt. Die Abschirmleiterbahn 22′ hat dabei vorteilhaft eine Breite B, die größer ist als die von ihr jeweils abgeschiedenen Leiterteile. Beispielsweise kann die Abschirmleiterbahn im Bereich der Verbindungsleiter 21a und 21b eine Breite B von etwa 300 »m haben, während die Verbindungsleiter jeweils eine Breite b von etwa 50 »m aufweisen. Die Entfernung e zwischen den Leiterteilen 20, 21a und 21b und der Leiterbahn 22′ ist dabei sehr gering und liegt z.B. zwischen 5 und 50 »m. Die Leiterbahn 22′ ist wiederum über die SQUID-Abschirmung 17 auf Erdpotential gelegt. Sie kann aus den genannten supraleitenden Materialien mittels bekannter Dünnfilmtechniken hergestellt werden.

Damit auch bei dieser Filmversion die Detektionsschleife 20 nicht gegen die zu messenden Magnetfelder abgeschirmt wird, ist wie bei der Drahtversion nach Figur 1 an einer Trennstelle 16 auf dem Umfang der Schleife 20 eine entsprechende Unterbrechung der Abschirmleiterbahn 22′ vorgesehen. Über diese Unterbrechung wird das Eindringen der Feldsignale 4 in die Detektionsschleife 20 erlaubt, die elektrische Abschirmung des aus den Leiterteilen 20, 21a, 21b und 7 gebildeten supraleitenden Flußtransformators 23 jedoch praktisch nicht beeinträchtigt.

Statt der insbesondere aus Figur 4 ersichtlichen einseitigen Abschirmung durch eine einzige Abschirmleiterbahn 22′ können gegebenenfalls die jeweiligen Leiterteile 20, 21a und 21b auch zwischen zwei entsprechend gestalteten Abschirmleiterbahnen verlaufen.

## Patentansprüche

1. SQUID-Meßeinrichtung (2; 19) zur Erfassung schwacher, sich zeitlich ändernder magnetischer Feldsignale (4) mindestens einer insbesondere biomagnetischen Feldquelle, welche Einrichtung (2, 19) mindestens einen Meßkanal enthält
- mit einem SQUID (11),
- mit einem dem SQUID (11) vorangeordneten supraleitenden Flußtransformator (10; 23), der wenigstens eine Detektionsschleife (3; 20) zum Empfang der Feldsignale (4) und wenigstens einen an die Detektionsschleife (3; 20) angeschlossenen Verbindungsleiter (6a, 6b; 21a, 21b) aufweist,
sowie
- mit mindestens einem supraleitenden Abschirmelement (15; 22), das zu einem elektrischen Abschirmen des wenigstens einen Verbindungsleiters (6a, 6b; 21a, 21b) und der wenigstens einen Detektionsschleife (3; 20) parallel zu diesen angeordnet ist und am Umfang der wenigstens einen Detektionsschleife (3; 20) eine Trennstelle (16) aufweist.

2. Einrichtung nach Anspruch 1, **dadurch gekennzeichnet**, daß das Abschirmelement (15) durch eine den jeweiligen Leiterteil (3, 6a, 6b) des Flußtransformators (10) umschließende Hülle (15′) gebildet ist.

3. Einrichtung nach Anspruch 2, **dadurch gekennzeichnet,** daß mehrere Verbindungsleiter (6a, 6b) des Flußtransformators (10) von der Abschirmhülle (15′) umschlossen sind.

4. Einrichtung nach Anspruch 2 oder 3, **dadurch gekennzeichnet**, daß zumindest die von der Abschirmhülle (15′) umschlossenen Leiterteile (3, 6a, 6b) des Flußtransformators (10) drahtförmig ausgebildet sind.

5. Einrichtung nach Anspruch 1, **dadurch gekennzeichnet**, daß das Abschirmelement (22) durch mindestens eine zu dem jeweiligen Leiterteil (20, 21a, 21b) des Flußtransformators (23) parallel verlaufende Leiterbahn (22′) gebildet ist.

6. Einrichtung nach Anspruch 5, **dadurch gekennzeichnet**, daß für mehrere Verbindungsleiter (21a, 21b) des Flußtransformators (23) eine gemeinsame Abschirmleiterbahn (22′) vorgesehen ist.

7. Einrichtung nach Anspruch 5 oder 6, **dadurch gekennzeichnet**, daß **d**ie Breite (B) der Abschirmleiterbahn (22′) größer als die des ihr jeweils zugeordneten mindestens einen Leiterteils (20, 21a, 21b) des Flußtransformators (23) ist.

8. Einrichtung nach einem der Ansprüche 5 bis 7, **dadurch gekennzeichnet**, daß zumindest die Abschirmleiterbahn (22′) und die ihr jeweils zugeordneten Leiterteile (20, 21a, 21b) des Flußtransformators (23) als Dünnfilme erstellt sind.

9. Einrichtung nach einem der Ansprüche 1 bis 8, **dadurch gekennzeichnet**,, daß das Abschirmelement (15, 22) vorzugsweise über eine Abschirmung (17) des SQUIDs (11) auf Erdpotential gelegt ist.

10. Einrichtung nach einem der Ansprüche 1 bis 9, **dadurch gekennzeichnet**, daß das Abschirmelement (15, 22) aus Nb oder Pb oder In oder aus einer Legierung oder Verbindung mit mindestens einem dieser Elemente besteht.

11. Einrichtung nach einem der Ansprüche 1 bis 10, **dadurch gekennzeichnet**, daß die Ausdehnung (a) der Trennstelle (16) längs des entsprechenden Schleifenleiters zwischen 0,1 und 0,5 mm liegt.

## Claims

1. SQUID measuring device (2; 19) for detecting weak magnetic field signals (4), which change over time, of at least one field source, in particular a biomagnetic field source, which device (2; 19) contains at least one measurement channel
- having a SQUID (11),
- having arranged in front of the SQUID (11) a superconducting flux transformer (10; 23), which has at least one detection loop (3; 20) for receiving the field signals (4) and at least one connecting conductor (6a, 6b; 21a, 21b) connected to the detection loop (3; 20),
and also
- having at least one superconducting screening element (15; 22), which in order to screen electrically the at least one connecting conductor (6a, 6b; 21a, 21b) and the at least one detection loop (3; 20) is arranged such that it is parallel to the at least one connecting conductor (6a, 6b; 21a, 21b) and the at least one detection loop (3; 20), and has on the periphery of the at least one detection loop (3; 20) a separation point (16).

2. Device according to claim 1, characterised in that the screening element (15) is formed by a sheath (15′) which surrounds the respective conductor part (3, 6a, 6b) of the flux transformer (10).

3. Device according to claim 2, characterised in that a plurality of connecting conductors (6a, 6b) of the flux transformer (10) are surrounded by the screening sheath (15′).

4. Device according to claim 2 or 3, characterised in that at least the conductor parts (3, 6a, 6b) of the flux transformer (10) that are surrounded by the screening sheath (15′) are shaped such that they are wire-like.

5. Device according to claim 1, characterised in that the screening element (22) is formed by at least one strip conductor (22′), which extends such that it is parallel to the respective conductor part (20, 21a, 21b) of the flux transformer (23).

6. Device according to claim 5, characterised in that a common screening strip conductor (22′) is provided for a plurality of connecting conductors (21a, 21b) of the flux transformer (23).

7. Device according to claim 5 or 6, characterised in that the width (B) of the screening strip conductor (22′) is greater than that of the at least one respective conductor part (20, 21a, 21b) of the flux transformer (23) that is associated with said screening strip conductor.

8. Device according to one of the claims 5 to 7, characterised in that at least the screening strip conductor (22′) and the conductor parts (20, 21a, 21b) of the flux transformer (23) that are respectively associated therewith are produced as thin films.

9. Device according to one of the claims 1 to 8, characterised in that the screening element (15, 22) is connected to earth potential preferably by way of a screening (17) of the SQUID (11).

10. Device according to one of the claims 1 to 9, characterised in that the screening element (15, 22) consists of Nb or Pb or In or of an alloy or compound having at least one of these elements.

11. Device according to one of the claims 1 to 10, characterised in that the extent (a) of the separation point (16) along the corresponding loop conductor is between 0.1 and 0.5 mm.

## Revendications

1. Système de mesure Squid (2; 19) pour détecter de faibles signaux (4) de champ magnétiques variables dans le temps d'au moins une source de champ en particulier biomagnétique, lequel système (2; 19) comporte au moins un canal de mesure comprenant
- un SQUID (11),
- un transformateur de flux (10; 23) supraconducteur disposé devant le SQUID (11) et comportant au moins une boucle détectrice (3; 20) pour la réception des signaux de champ (4) et au moins un conducteur de liaison (6a, 6b; 21a, 21b) connecté à la boucle détectrice
ainsi que
- au moins un élément de blindage (15; 22) supraconducteur, qui, en vue d'un blindage électrique du - au moins un - conducteur de liaison (6a, 6b; 21a, 21b) et de la - au moins une - boucle détectrice (3; 20), est disposé parallèlement à ceux-ci et présente à la périphérie de ladite boucle détectrice (3; 20) un point de rupture (16).

2. Système selon la revendication 1, caractérisé en ce que l'élément de blindage (15) est formé par une gaine (15′) entourant la partie respective (3, 6a, 6b) du conducteur du transformateur de flux (10).

3. Système selon la revendication 2, caractérisé en ce que plusieurs conducteurs de liaison (6a, 6b) du transformateur de flux (10) sont entourés de la gaine de blindage (15′).

4. Système selon la revendication 2 ou 3, caractérisé en ce qu'au moins les parties (3, 6a, 6b) du conducteur du transformateur de flux (10), qui sont entourées de la gaine de blindage (15′), se présentent sous forme de fils.

5. Système selon la revendication 1, caractérisé en ce que l'élément de blindage (22) est formé par au moins une piste conductive (22′) s'étendant parallèlement à la partie respective (20, 21a, 21b) du conducteur du transformateur de flux (23).

6. Système selon la revendication 5, caractérisé en ce qu'une piste conductive de blindage commune (22′) est prévue pour plusieurs conducteurs de liaison (21a, 21b) du transformateur de flux (23).

7. Système selon la revendication 5 ou 6, caractérisé en ce que la largeur (B) de la piste conductive de blindage (22′) est supérieure à celle de l'une au moins des parties (20, 21a, 21b) du conducteur du transformateur de flux (23), qui lui est respectivement attribuée.

8. Système selon l'une des revendications 5 à 7, caractérisé en ce qu'au moins la piste conductive de blindage (22′) et les parties (20, 21a, 21b) du conducteur du transformateur de flux (23), qui lui sont respectivement attribuées, sont conçues sous forme de couches minces.

9. Système selon l'une des revendications 1 à 8, caractérisé en ce que l'élément de blindage (15, 22) est mis au potentiel de la terre de préférence par l'intermédiaire d'un blindage (17) du Squid (11).

10. Système selon l'une des revendications 1 à 9, caractérisé en ce que l'élément de blindage (15, 22) est composé de Nb ou Pb ou In, ou d'un alliage ou d'une combinaison comportant au moins l'un de ces éléments.

11. Système selon l'une des revendications 1 à 10, caractérisé en ce que l'extension (a) du point de rupture (16) le long de la boucle est comprise entre 0,1 et 0,5 mm.
